(19) Europäisches Patentamt
European Patent Office
Office européen des brevets

(11) **EP 1 922 587 B1**

(12) **EUROPÄISCHE PATENTSCHRIFT**

(45) Veröffentlichungstag und Bekanntmachung des Hinweises auf die Patenterteilung:
**05.08.2015 Patentblatt 2015/32**

(21) Anmeldenummer: **06777152.7**

(22) Anmeldetag: **02.09.2006**

(51) Int Cl.:
***G03F 7/20*** *(2006.01)*

(86) Internationale Anmeldenummer:
**PCT/EP2006/008581**

(87) Internationale Veröffentlichungsnummer:
**WO 2007/028553 (15.03.2007 Gazette 2007/11)**

(54) **VERFAHREN ZUR BESTIMMUNG DER INTENSITÄTSVERTEILUNG IN DER BILDEBENE EINER PROJEKTIONSBELICHTUNGSANLAGE**

METHOD FOR DETERMINING INTENSITY DISTRIBUTION IN THE FOCAL PLANE OF A PROJECTION EXPOSURE ARRANGEMENT

PROCEDE POUR DETERMINER UNE REPARTITION D'INTENSITES DANS LE PLAN FOCAL D'UNE INSTALLATION D'EXPOSITION PAR PROJECTION

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **05.09.2005 DE 102005042496**

(43) Veröffentlichungstag der Anmeldung:
**21.05.2008 Patentblatt 2008/21**

(73) Patentinhaber: **Carl Zeiss SMT GmbH**
**73447 Oberkochen (DE)**

(72) Erfinder:
• GREIF-WÜSTENBECKER, Jörn Dr.
 1030 Wien (AT)
• BÖHME, Beate
 07751 Grosspürschütz (DE)
• MATEJKA, Ulrich
 07743 Jena (DE)
• TOTZECK, Michael
 73525 Schwäbisch Gmünd (DE)
• KAMENOV, Vladimir Dr.
 73457 Essingen (DE)
• DITTMANN, Olaf Dr.
 73441 Bopfingen (DE)
• GRUNER, Toralf
 73433 Aalen-Hofen (DE)
• KRÄHMER, Daniel Dr.
 734571 Essingen (DE)
• GEH, Bernd
 Scottsdale, AZ 85254 (US)

(74) Vertreter: **Geyer, Fehners & Partner**
**Patentanwälte**
**Sellierstrasse 1**
**07745 Jena (DE)**

(56) Entgegenhaltungen:
**EP-A1- 0 689 099      EP-A2- 0 628 806**
**WO-A2-03/092256      US-A1- 2001 007 495**

**Beschreibung**

Die Erfindung betrifft ein Verfahren, bei dem ein Abbildungssystem mit hoher Apertur emuliert wird, wobei von einer Probe kommendes Licht mit einem Emulationsabbildungssystem auf einen ortsauflösenden Detektor abgebildet wird.

Bei dem emulierten Abbildungssystem kann es sich insbesondere um einen Photolithographie-Scanner handeln, der zur Herstellung mikroelektronischer Schaltkreise verwendet wird. Dazu werden photolithographische Masken verwendet, deren Strukturen auf mit Photolack beschichtete Wafer abgebildet werden, so daß der Lack belichtet wird und an den belichteten Stellen die Struktur auf dem Wafer verändert wird.

Mit Emulationsabbildungssystemen emuliert man einen solchen Photolithographie-Scanner. Während der Scanner die Struktur der Maske jedoch verkleinert auf den zu belichtenden Träger abbildet, wird ein Emulationsabbildungssystem in Maskeninspektionssystemen eingesetzt, wobei die Struktur vergrößert auf einen Detektor abgebildet wird. Bei beiden Systemen ist die maskenseitige numerische Apertur gleich, bildseitig unterscheiden sie sich jedoch. Die bildseitige numerische Apertur bei einem Maskeninspektionssystem einerseits liegt etwa bei 0. Auf der anderen Seite erfordern immer kleiner werdende Objektstrukturgrößen immer größere abbildungsseitige numerische Aperturen von 0,8 und mehr im Photölithographie-Scanner. Dies führt zu Abweichungen in den Abbildungen von dem Maskeninspektionssystem und dem Photolithographie-Scanner, die insbesondere in Fällen, in denen die numerische Apertur des Scanners im Verhältnis zur Brechzahl im Photolack größer als 0,8/1,7 ist, nicht mehr vernachlässigbar sind. Zu diesen Abweichungen bzw. im Scannersystem auftretenden Defekten zählt auch die sogenannte Apodisierung: Die Transmission des Lichts im Photolack in Abhängigkeit vom Einfallswinkel ist nicht konstant, sondern nimmt zu großen Einfallswinkeln hin zu.

Im Stand der Technik spielen die abbildungsseitigen Unterschiede zwischen dem Photolithographie-Scanner und dem Emulationsabbildungssystem zur Mäskeninspektion nur eine untergeordnete Rolle. In der Halbleiterindustrie wird allerdings für die Zukunft der Einsatz von Immersionssystemen zur Herstellung von Waferstrukturen, die kleiner als 65nm sind, favorisiert. Durch das Aufbringen einer Immersionsflüssigkeit auf den Wafer werden abbildungsseitig numerische Aperturen NA > 1 erreicht, so daß bei gleicher Wellenlänge kleinere Strukturen erzeugt werden können. So kann beispielsweise bei der Verwendung von Wasser als Immersionsflüssigkeit unter Beleuchtung mit Licht einer Wellenlänge von $\lambda$=193nm eine numerische Apertur von maximal 1,4 erreicht werden. Mit anderen Immersionsflüssigkeiten können sogar noch größere numerische Aperturen erreicht werden. Bei einem Reduktionsfaktor von 1:4 sind für Waferstrukturen von 65nm bzw. 45nm Maskenstrukturen von 260nm bzw. 180nm erforderlich, die Maskenstrukturen liegen somit im Bereich der Abbildungswellenlänge von derzeit 193nm. Bei kleineren Sturkuren wird die Analyse von Defekten in den zu verwendenden Masken immer wichtiger. Ein zur Analyse beispielsweise geeignetes Maskeninspektionssystem ist das AIMS™ (Areal Imaging Measurement System) der Carl Zeiss SMS GmbH. Ein kleiner Bereich der Maske (Defektort) wird unter den gleichen Beleuchtungs- und Abbildungsbedingungen (Wellenlänge, numerische Apertur) wie im Photolithographie-Scanner beleuchtet und abgebildet. Im Gegensatz zum Photolithographie-Scanner wird jedoch das von der Maske erzeugte Bild vergrößert und auf eine CCD-Kamera abgebildet. Die Kamera sieht das gleiche Bild wie der Photolack auf dem Wafer. Somit kann ohne aufwendige Testprints das Luftbild analysiert werden. Bei diesem System - ebenso wie bei den anderen im Stand der Technik bekannten Systemen - wird die Abweichung in der Apodisierung in bezug auf den Photolithographie-Scanner nicht berücksichtigt, da die numerischen Aperturen noch so klein sind, daß die Abweichungen bisher keine Rolle gespielt haben. Da jedoch in Zukunft damit zu rechnen ist, daß im Photolithographie-Scanner maskenseitig höhere Aperturen verwendet werden, kommt diesen Abweichungen eine größere Bedeutung zu.

In der US 2001/0007495 A1 werden ein Verfahren und eine Vorrichtung für die Projektionsbelichtung unter Verwendung von Phasenverschiebungsmasken beschrieben, die für die Herstellung von Mikro-Schaltkreisstrukturen geeignet ist. Eine Maske wird beleuchtet, dieses Licht wird anschließend auf einen mit Photolack beschichteten Wafer gelenkt. Zur Realisierung verschiedener Beleuchtungseinstellungen werden Filter verwendet, die einer Ortsraumfilterung in einer Pupillenebene entsprechen und jeweils verschiedene Intensitätsverteilungen generieren. Diese Intensitätsverteilungen werden zur Überprüfung und ggf. Korrektur detektiert.

In der EP 0 689 099 A1 wird eine Projektionsbelichtungsanlage ebenfalls für die Mikrolithographie beschrieben, sowie ein Verfahren für die Mikrolithographie. Die Lichtverteilung kann mittels variabel einstellbarer Blenden variiert werden, die Intensitätsverteilung wird detektiert, so daß ggf. Änderungen an den optischen Einstellungen vorgenommen werden können um beispielsweise auf geänderte Charakteristika der optischen Elemente und eine geänderte Temperaturverteilung mit Korrekturen reagieren zu können.

In der WO 03/092256 A2 werden ebenfalls ein Projektionsverfahren und ein Projektionssystem für die Photolithographie beschrieben. Dabei wird auf die Verwendung von Pupillenfiltern - die optische Filterung bzw. Apodisierung - zur Verbesserung der Auflösung und der Schärfentiefe eingegangen. Um das an sich bekannte umständliche und ungenaue Auswechseln von Filtern in einer Pupillenebene zu vermeiden, geht man hier den Weg einer winkelselektiven Filterung in einer Feldebene - beispielsweise im Bereich der Bildebene oder der Objektebene -, die im feldnahen Bereich die gleiche Wirkung, wie eine ortsselektive Filterung im Bereich der Pupille hat.

In der EP 0 628 806 A2 wird eine Projektionsbelichtungsanlage beschrieben, bei der eine Maske vergrößert auf einen ortsauflösenden Detektor abgebildet wird.

Aufgabe der vorliegenden Erfindung ist es daher, Wege zu finden, mit denen die Abbildungsverhältnisse in bezug auf das Apodisierungsverhalten zwischen Maskeninspektionssystem einerseits und Photolithographie-Scanner andererseits aneinander angeglichen werden.

Diese Aufgabe wird bei einem Verfahren, bei dem eine Maske beleuchtet, das von der Maske kommende Lichte auf einen ortsauflösenden Detektor gelenkt, ein Signal mit dem ortsauflösenden Detektor aufgezeichnet und daraus die Intensitätsverteilung berechnet wird, wobei bei dieser Berechnung die numerische Apertur in der Bildebene einer als Emulationsabbildungssystem ausgestalteten Projektionsbelichtungsanlage berücksichtigt wird, dadurch gelöst, daß in der Austrittspupille eine komplexe Amplitudenverteilung bestimmt wird, die Amplitudenverteilung mit einer vorgegebenen Apodisierungskorrektur verknüpft wird, und aus der geänderten Amplitudenverteilung ein Bild mit korrigierter Apodisierung berechnet wird. Die Intensität korrespondiert zum Quadrat des Betrags der komplexen Amplitude.

In einer vorteilhaften Ausgestaltung der Erfindung wird dazu in der Bildebene die Phasenverteilung des einfallenden Lichts bestimmt, anhand der Phasenverteilung die komplexe Amplitudenverteilung in der Austrittspupille rekonstruiert, die rekonstruierte Amplitudenverteilung mit einer vorgegebenen Apodisierungskorrektur verknüpft und aus der geänderten Amplitudenverteilung ein Bild mit korrigierter Apodisierung berechnet.

In einer weiteren vorteilhaften Ausgestaltung der Erfindung wird die komplexe Amplitudenverteilung dadurch bestimmt, indem in der Bildebene die Phasenverteilung des einfallenden Lichts berechnet wird und anhand der Phasenverteilung die komplexe Amplitudenverteilung rekonstruiert wird.

Durch die Bestimmung der Phasenverteilung in der Bildebene läßt sich rechnerisch mit bekannten Methoden wie einer zweidimensionalen Fouriertransformation oder einem Phase-Retrival bestimmen, welcher Strahl in der Austrittspupille, in der die von einem Objektpunkt ausgehenden Strahlen alle parallel laufen, zu welchem Punkt in der Bildebene führt. Die Phase selbst läßt sich mit aus dem Stand der Technik bekannten Methoden messen. Beispielsweise kann man mehrere Bilder vor, in und hinter der Fokusebene aufnehmen und anschließend rechnerisch die Phasenwerte mit einem rekursiven Auswerteverfahren rekonstruieren. Auch eine direkte Messung der Phasenwerte, beispielsweise mit dem Shack-Hartmann-Verfahren ist möglich, auch ein phasenschiebendes Lateral-Sheering-Interferometer kann zur Bestimmung der Phasenverteilung eingesetzt werden. Kennt man die Phasenverteilung, so läßt sich die komplexe Amplitudenverteilung in der Austrittspupille rechnerisch rekonstruieren. Diese rekonstruierte Amplitudenverteilung wird dann mit einer vorgegebenen Apodisierungskorrektur verknüpft, wodurch sich eine geänderte Amplitudenverteilung ergibt. Aus dieser kann schließlich wiederum ein Bild berechnet werden, in dem die Korrektur der Apodisierung berücksichtigt ist.

Vorteilhaft wird dabei die komplexe Amplitudenverteilung nicht für jeden Punkt in der Pupillenebene bestimmt, sondern nur für eine Anzahl Punkte mit den Koordinaten (p,q). Nur für diese Punkte wird die Amplitudenverteilung mit der Apodisierungskorrektur verknüpft. Für die Berechnung der Zwischenwerte können übliche Interpolationsverfahren verwendet werden.

Je nach Aufgabenstellung kann dabei die Apodisierungskorrektur auf verschiedene Weise vorgegeben werden. So kann man beispielsweise als Apodisierungskorrektur eine Apodisierung vorgeben, die im wesentlichen der im Emulationsabbildungssystem vorhandenen Apodisierung entspricht, und die Amplitudenverteilung durch diese Apodisierung dividieren. Auf diese Weise läßt sich die vorhandene Apodisierung im System mindestens teilweise kompensieren. Zweckmäßig wird man als Apodisierungskorrektur die natürliche oder auch die technische Apodisierung, sofern bekannt, vorgeben, oder auch beide zusammen.

Bevorzugt wird man jedoch als Apodisierungskorrektur eine im wesentlichen der im emulierten Abbildungssystem vorhandenen Apodisierung entsprechende Apodisierung vorgeben und die Amplitudenverteilung mit dieser multiplizieren. Auf diese Weise läßt sich die im emulierten Abbildungssystem vorhandene Apodisierung mindestens näherungsweise erzeugen, so daß man die dort herrschenden Bedingungen bestmöglichst nachahmt. Zweckmäßigerweise gibt man als Apodisierungskorrektur auch hier die natürliche Apodisierung oder die technische Apodisierung, oder auch beide Apodisierungen, die im emulierten Abbildungssystem vorhanden sind, vor. Dies ist insbesondere dann von Bedeutung, wenn es sich bei dem emulierten Abbildungssystem um einen Photolithographie-Scanner handelt, da genau auf diese Weise die im Photolithographie-Scanner herrschenden Bedingungen bestens nachgeahmt werden können. Um diese Bedingungen möglichst getreu nachbilden zu können, ist es vorteilhaft, die Apodisierungskorrektur in Abhängigkeit von der numerischen Apertur des Scanners und vom emulierten Photolack vorzugeben. Die Apodisierung des Photolithographie-Scanners läßt sich dann durch Multiplikation der Amplitudenverteilung in der Austrittspupille mit dem Faktor $1/\cos\theta'$ emulieren, wobei $\theta'$ der Einfallswinkel des Lichts im emulierten Photolack ist. Die natürliche Apodisierung $T(p,q)$ des Photolithographie-Scanners kann auch gemäß des Ausdrucks

$$T(p,q) = \left( \frac{1}{1 - \left(\dfrac{p}{n'}\right)^2 - \left(\dfrac{q}{n'}\right)^2} \right)^{\frac{1}{4}}$$

bestimmt werden, wobei T die Amplitudentransmission, n' die Brechzahl des verwendeten Photolacks, und (p,q) die dimensionslosen Pupillenkoordinaten sind.

Außer der rechnerischen Berücksichtigung der im Scanner vorhandenen Apodisierung wird die Aufgabe bei einem Verfahren zur Bestimmung der Intensitätsverteilung in der Bildebene einer als Emulationsabbildungssystem ausgestalteten Projektionsbelichtungsanlage, bei dem eine Maske beleuchtet wird, mindestens ein intensitätsveränderndes optisches Element ausgewählt wird, mit dem eine vorgegebene Intensitätsverteilung in der Austrittspupille erzeugt wird, das mindestens eine intensitätsverändernde optische Element in den Strahlengang zur Veränderung der Apodisierung eingebracht oder zugeschaltet wird, von der Maske kommende Licht durch dieses intensitätsverändernde optische Element auf einen ortsauflösenden Detektor gelenkt wird, wobei das intensitätsverändernde optische Element in Abhängigkeit von der numerischen Apertur in der Bildebene der Projektionsbelichtungsanlage gewählt wird,auch dadurch gelöst, daß eine im wesentlichen der natürlichen und/oder technischen Apodisierung des emulierten Abbildungssystems entsprechende Intensitätsverteilung vorgegeben wird, so daß diese wenigstens näherungsweise erzeugt wird.

Die natürliche Apodisierung wird dabei gemäß des Ausdrucks

$$\sqrt{\frac{n \cos\theta}{n' \cos\theta'}}$$

bestimmt. n und θ sind Brechungsindex bzw. Einfallswinkel des Lichts im Objektraum, d.h. in der Maske, n' und θ' sind die entsprechenden Größen im Bildräum, d.h. auf dem Wafer, wobei n' und θ' sich auf den Photolack beziehen.

Mit dem in den Strahlengang eingebrachten oder zugeschalteten, intensitätsverändernden optischen Element wird dann eine vorgegebene Intensitätsverteilung in der Austrittspupille erzeugt. Vorteilhaft kann dieses intensitätsverändernde optische Element zur Erzeugung einer vorgegebenen Intensitätsverteilung angesteuert werden. Auf diese Weise können beispielsweise durch verschiedene Photolacke zustandekommende unterschiedliche Apodisierungen im Photolithographie-Scanner berücksichtigt werden. Eine andere Möglichkeit besteht darin, dieses intensitätsverändernde optische Element auszuwechseln, wobei diese Auswechslung auch automatisch erfolgen kann.

In der Regel wird man zur Intensitätsveränderung intensitätsabschwächende Elemente wie Filter verwenden. Denkbar ist aber auch eine Ausgestaltung des Verfahrens, in dem die Intensität durch das intensitätsverändernde optische Element verstärkt wird.

Wird ein Photolithographie-Scanner emuliert, so gibt man vorteilhaft die Intensitätsverteilung in Abhängigkeit von der numerischen Apertur des Scanners und vom emulierten Photolack vor.

Im einfachsten Fall ist als intensitätsveränderndes optisches Element ein Filter vorgesehen. Auch mehrere Filter können vorgesehen sein, die Filter können auch auswechselbar angeordnet sein, so daß je nach emuliertem System ein anderer Filter eingesetzt oder auch zugeschaltet werden kann. Beispielsweise lassen sich die Filter auf einem Rad anordnen und können dann über eine Benutzerschnittstelle jeweils in den Strahlengang eingeführt werden.

Ist der Filter austauschbar gestaltet, kann man die technische Apodisierung für verschiedene Scanner emulieren. Die Filter lassen sich an verschiedene Brechungsindizes des zu emulierenden Photolacks anpassen. Außerdem kann ein solcher Filter auch so gestaltet werden, daß er nur eine kleinere als die maximal mögliche numerische Apertur abdeckt, dafür aber eine höhere Gesamttransmission aufweist. Nachteil bei austauschbar gestalteten Filtern ist die hohe mechanische Präzision, die erforderlich ist. So muß die Fassungstechnik sehr präzise sein. Außer der Abschwächung wird die Absorptionsschicht außerdem auch einen gewissen Phasenhub verursachen. Dieser muß in einem austauschbaren Filter in diesem selbst kompensiert werden. Bei einem nicht austauschbaren Filter hingegen läßt sich der Phasenhub bei der Objektivjustage automatisch wegjustieren.

In einer bevorzugten Ausführung der Erfindung ist der Filter daher direkt auf eine der Objektivlinsen aufgebracht. Dies kann beispielsweise durch Aufdampfen geschehen.

In einer weiteren bevorzugten Ausführung sind wenigstens zwei intensitätsverändernde optische Elemente, bevorzugt Filter, vorgesehen. Eines der Elemente weist eine starke intensitätsverändernde Wirkung auf und korrigiert beispielsweise die Apodisierung weitestgehend. Hier ist der Phasenhub auch wegjustiert. Mit dem oder den austauschbaren Elementen läßt sich dann noch eine Anpassung an den jeweiligen zu emulierenden Photolack vornehmen. Die intensitätsverändernde Wirkung ist hier wesentlich schwächer, der Phasenhub spielt daher nur eine untergeordnete Rolle.

Statt eines Filters ist in einer bevorzugten Ausgestaltung der Erfindung als intensitätsveränderndes optisches Element ein intensitätsverstärkendes Medium vorgesehen, besonders bevorzugt wird hier ein Laser, insbesondere ein bevorzugt zuschaltbar ausgeführter Festkörperlaser eingesetzt. Ein solcher Laser kann z.B. realisiert werden, indem ein dünner dotierter Kristall in der Pupillenebene platziert und senkrecht zur optischen Achse von mindestens einer Seite gepumpt wird. Damit es zu einer Abbildung kommt, müssen die Photonen in den Beugungsordnungen phasenrichtig überlagern. Beim Durchtritt der Photonen durch den Kristall werden weitere Photonen durch stimulierte Emission orientierungs- und phasenrichtig verstärkt. Welche Beugungsordnung die stark verstärkt wird, hängt von dem Kristalldotierungsverlauf und dem optischen Pumpvorgang ab. Der Einsatz eines aktiven, intensitätsverstärkenden Mediums vermeidet das Auftreten von Energieverlusten, wie sie beim Einsatz von Filtern entstehen. Insbesondere in Mikroskopen ist jedoch die Energiedichte schon relativ gering, so daß sich eine weitere Verminderung durch Filter unter Umständen negativ auswirken könnte.

Da der Strahlengang im. Mikroskop üblicherweise rotationssymmetrisch ist, wird das intensitätsverändernde optische Element zweckmäßig so ausgestaltet, daß es die Intensität im wesentlichen rotationssymmetrisch um die optische Achse verändert. Ein Filter kann dabei je nach Applikation so ausgestaltet sein, daß seine Transmission von der Mitte zum Rand hin entweder zu- oder abnimmt. Soll beispielsweise die Emulation in einem Scannersystem emuliert werden, so muß die Transmission zum Rand hin zunehmen. In der am einfachsten zu realisierenden Form ist das intensitätsverändernde optische Element zweckmäßig in oder in der Nähe einer Pupillenebene, in der die von einem Objektpunkt ausgehenden Strahlen parallel laufen bzw. Strahlen, die von verschiedenen Objektpunkten unter dem gleichen Winkel ausgehen, am gleichen Ort zusammentreffen, angeordnet. Auf diese Weise läßt sich beispielsweise die natürliche Apodisierung eines Photolithographie-Scanners emulieren, wenn das intensitätverändernde optische Element die Intensität im wesentlichen entsprechend des Ausdrucks

$$I = \frac{C}{\sqrt{1 - \left(\frac{rNA}{r_0' n_r}\right)^2}}$$

verändernd ausgestaltet ist. I ist dabei die Transmission der Intensität, $r_0$ der Radius der Abbildungspupille, r der Abstand zu optischen Achse, $n_r$ der Brechungsindex im emulierten Photolack, NA die numerische Apertur des Photolithographie-Scanners und C eine wählbare Konstante. Wählt man als Konstante den Wert 1, so muß das intensitätsverändernde optische Element die Intensität verstärken. Wählt man jedoch die Konstante kleiner oder gleich dem Maximum des unter dem Bruchstrich stehenden Ausdrucks, so kann das optische Element rein abschwächend ausgeführt werden - die Transmission übersteigt in diesem Fall nicht 100%.

In einer anderen bevorzugten Ausgestaltung der Erfindung ist das intensitätsverändernde optische Element in einer Fläche mit hoher Winkelbelastung angeordnet. Beispielsweise kann ein Filter auf eine gekrümmte Linsenfläche aufgedampft werden. Die Transmission durch dieses Element wird dann winkel- und polarisationsabhängig. Mit einer entsprechenden Beschichtung kann man auf diese Weise Fresnelreflexe emulieren, die an der Grenzfläche beim Übergang von Luft bzw. Immersionsflüssigkeit in den Photolack entstehen. Man ist jedoch nicht beschränkt, den Filter auf eine Linsenoberfläche aufzubringen, alternativ kann man ihn auch an eine Stelle in den Strahlengang einbringen, wo die Strahlen eine hohe numerische Apertur aufweisen.

Bei der Anordnung des optischen Elements in einer Fläche mit hoher Winkelbelastung kann man sich zwei wesentliche Effekte zu Nutzen machen und das Material entsprechend gestalten: Zum einen die Volumenabsorption in Abhängigkeit vom Eintrittswinkel, die dadurch zustande kommt, daß schräge Strahlen in planparallelen Platten längere Wege durchlaufen; und zum anderen eine Abhängigkeit der Reflexion an einer Oberfläche vom Einfallswinkel des Lichts. Der erste Effekt läßt sich selbstverständlich auch bei positiv oder negativ brechenden Linsen ausnutzen, wo Strahlen, die in der Nähe der optischen Achse in die Linse eintreten, in dieser einen längeren bzw. kürzeren Weg zurücklegen als Randstrahlen.

Anstelle von Veränderungen der Apodisation im Emulationsabbildungssystem kann man auch, was nicht Gegenstand der Erfindung ist, im Strahlengang eines Photolithographie-Scanners selbst, d.h. des emulierten Systems ein oder mehrere intensitätsverändernde optische Elemente zur Variation der Apodisierung vorsehen. Auf diese Weise lassen sich natürliche und/oder technische Apodisierungen des Scannersystems korrigieren, so daß eine Korrektur im Emulationssystem unter Umständen überflüssig wird. Bevorzugt ist auch hier das optische Element in oder in der Nähe einer Pupillenebene auswechselbar angeordnet. Zweckmäßigerweise korrigiert das optische Element die natürliche und/oder die technische Apodisierung in Abhängigkeit vom verwendeten Photolack. In einer bevorzugten Ausgestaltung der Erfindung weist das optische Element eine Amplitudentransmission T(p,q) mit den Pupillenkoordinaten (p,q) gemäß des Ausdrucks

$$T(p,q) = \left(\frac{1 - (\beta p)^2 - (\beta q)^2}{1 - \left(\frac{p}{n'}\right)^2 - \left(\frac{q}{n'}\right)^2}\right)^{-\frac{1}{4}}$$

auf, wobei β die Vergrößerung und n' die Brechzahl des verwendeten Photolacks ist.

Die Erfindung soll im folgenden anhand von Ausführungsbeispielen näher erläutert werden.

In den dazu gehörigen Zeichnungen zeigt

Fig.1a     einen Photolithographie-Scanner, wie er aus dem Stand der Technik bekannt ist,

Fig.1b     ein Maskeninspektionssystem aus dem Stand der Technik,

Fig.2     das Emulationsabbildungssystem, d.h. den in bezug auf die Maske bildseitigen Teil des Maskeninspektionssystems, wie es derzeit im Stand der Technik existiert,

Fig.3a     eine erste Ausgestaltung der Erfindung mit einem Pupillenfilter,

Fig.3b     dessen Transmission zur Emulation der natürlichen Apodisierung,

Fig.4     eine weitere Ausgestaltung der Erfindung, in der das optische Element in einer Fläche mit hoher Winkelbelastung anordnet ist,

Fig.5     eine weitere Ausgestaltung der Erfindung, in der das optische Element ebenfalls in einer Fläche mit hoher Winkelbelastung angeordnet ist,

Fig.6     eine Alternative zur Intensitätsveränderung bei optischen Elementen in Flächen mit hoher Winkelbelastung, und

Fig.7     eine Ausgestaltung, die sich das Zurücklegen unterschiedlicher Weglängen in einer der Linsen zunutze macht.

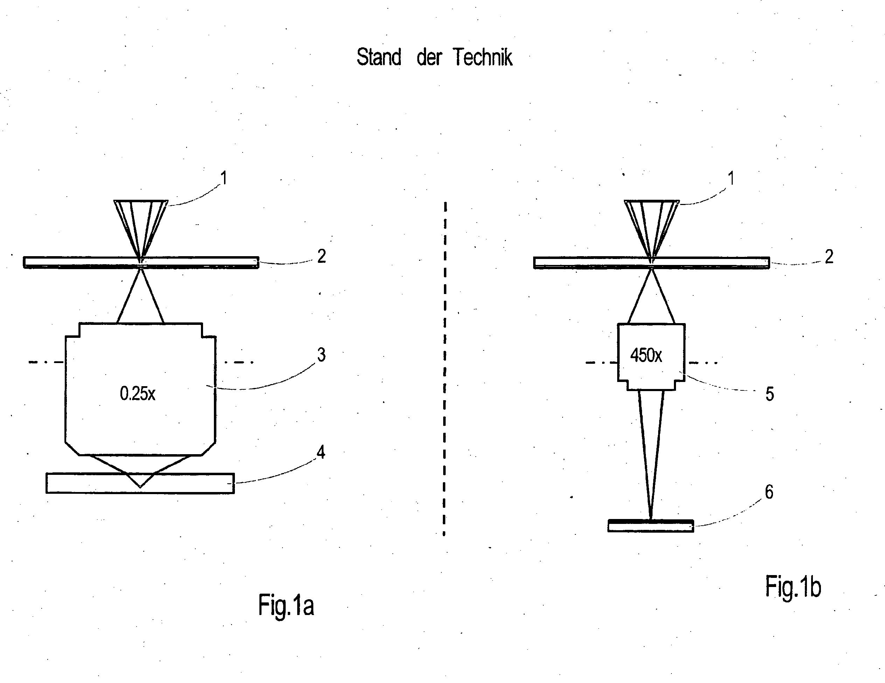

In Fig.1a ist ein Photolithographie-Scanner, wie er aus dem Stand der Technik, gezeigt. Lichtstrahlen 1 aus einer nicht gezeigten Beleuchtungsquelle fallen auf ein Objekt oder eine Maske 2, die in ein einer Feldebene anordnet ist. Die Strahlen treten dann in das Scannerabbildungssystem 3, welches die Maske 2 im hier gezeigten Beispiel um einen Faktor 4 verkleinert in eine auf einem Wafer aufgebrachte Photolackschicht 4 abbildet. An den lichtdurchlässigen Stellen wird der Photolack belichtet. Durch die anschließende Entwicklung wird das Bild der Maske 2 auf den Wafer reproduziert.

Da die Herstellung der Masken sehr aufwendig und kostenintensiv ist und diese Kosten steigen, je kleiner die verwendeten Strukturen werden, testet man die Masken vor dem Einsatz in den Photolithographie-Scannern üblicherweise auf Fehler. Dazu kann das in Fig.1b beispielhaft gezeigte Maskeninspektionssystem, beispielsweise das AIMS™ der Firma Carl Zeiss SMS GmbH verwendet werden. Bis zu der gestrichelten Linie durch das Abbildungssystem, die auch in Fig.1a eingezeichnet ist, sind beide Systeme identisch, d.h. in beiden Systemen wird dieselbe Wellenlänge, eine entsprechende Beleuchtungsquelle und dieselbe Beleuchtungpolarisation verwendet, ebenso sind die maskenseitigen numerischen Aperturen gleich. Während jedoch das Bild der Maske 2 im Scannerabbildungssystem 3 verkleinert in die Photolackschicht 4 abgebildet wird, so wird im hier gezeigten Beispiel durch das Emulationsabbildungssystem 5 die Masken 2 mit hier beispielhaft gewählter 450-facher Vergrößerung auf eine CCD-Kamera 6 abgebildet. Auch andere Vergrößerungen sind selbstverständlich möglich. Während also die numerische Apertur im Falle des Scanners bildseitig sehr groß ist, so ist die numerische Apertur im Maskeninspektionssystem sehr klein. Aus diesem Unterschied resultiert eine unterschiedliche Apodisierung.

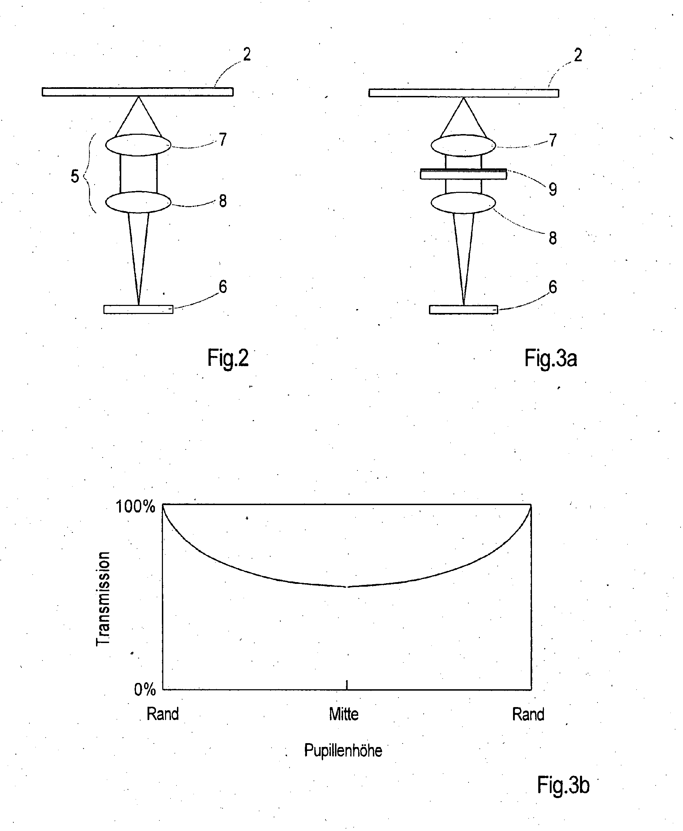

Die Apodisierung kann im Maskeninspektionssystem auf verschiedene Weisen kompensiert werden. Zunächst zeigt Fig.2 noch einmal das Emulationsabbildungssystem 5 detaillierter skizziert mit zwei Linsensystemen 7 und 8, zwischen denen die Strahlen näherungsweise parallel laufen.

In einer ersten Ausgestaltung der Erfindung in Fig. 3a ist in einer Pupillenebene oder einer pupillennahen Ebene - in diesem Falle zwischen den Linsensystemen 7 und 8 - ein Filter 9 eingebracht, der die Transmission der Intensität rotationssymmetrisch in Abhängigkeit vom Abstand zur optischen Achse gemäß der Formel

$$I = \frac{C}{\sqrt{1 - \left(\dfrac{rNA}{r_0 n_r}\right)^2}}$$

verändert, wie in Fig.3b gezeigt. Dabei wurde die Konstante C < 1 so gewählt, daß die Transmission am Pupillenrand 100% beträgt. Im gezeigten Bespiel beträgt die numerische Apertur 1,4 und der Brechungsindex im Photolack 1,72. Anstelle des Filters kann auch ein intensitätsverstärkendes Medium eingesetzt werden.

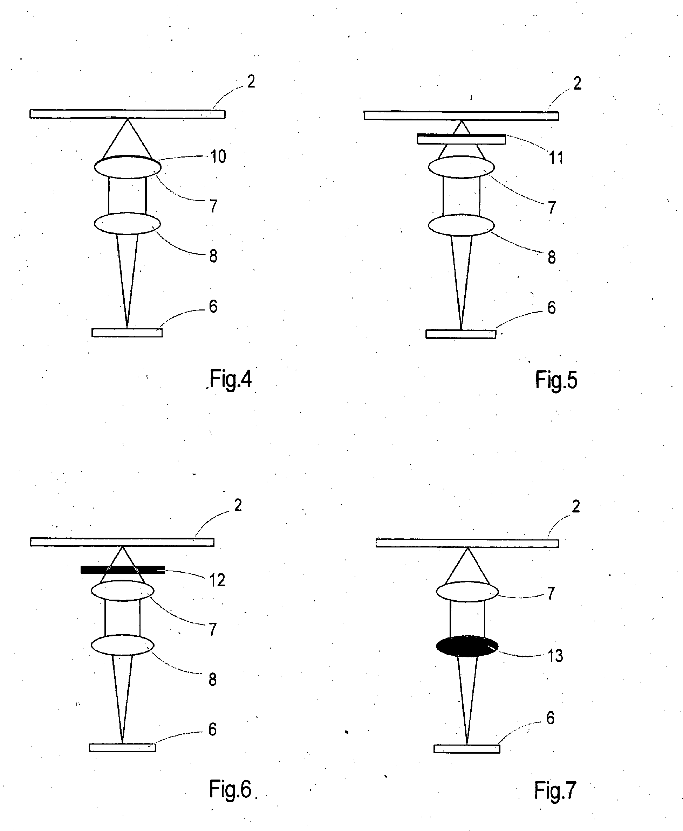

Eine zweite Ausgestaltung der Erfindung ist in Fig. 4 gezeigt. Hier wurde der Filter 10 auf eine stark gewölbte Fläche des Linsensystems 7 aufgedampft, die hier in maskenseitiger Lage gezeigt ist, aber nicht auf diese Lage beschränkt ist, sondern auch an anderen Stellen liegen kann. Die Fläche ist gewölbt und weist außerdem eine hohe Winkelbelastung auf, d.h., die von einem Objektpunkt kommenden Strahlen treffen unter großen Winkeln auf den Filter 10. Für die Wahl der Fläche ist allein die Winkelbelastung ausschlaggebend. Alternativ kann man auch einen Filter 11 mit ebener Fläche zwischen Maske 2 und Linsensystem 7, oder eine andere Position, an der eine hohe numerische Apertur vorliegt, einbringen. In beiden Fällen muß die Beschichtung so gewählt sein, daß sie die Transmission des Lichts in Abhängigkeit vom Einfallswinkel beeinflußt. Beispielsweise kann eine Schicht verwendet werden, deren Reflexionsverhalten abhängig vom Einfallswinkel des Lichts ist.

In Fig.6 ist eine weitere Ausgestaltung der Erfindung gezeigt. Statt einer Beschichtung, deren Filtereigenschaften abhängig vom Einfallswinkel des Lichts sind, wird hier an der gleichen Stelle ebenfalls mit hoher Winkelbelastung eine planparallele Platte 12 in den Strahlengang zwischen Maske 2 und Linsensystem 7 gebracht. Bei diesem Filterelement macht man sich den Effekt zu nutze, daß unter verschiedenen Winkeln einfallende Strahlen in der Platte verschiedene Weglängen zurücklegen. Je größer der Einfallswinkel in Bezug auf die Oberflächennormale ist, desto länger ist der zurückzulegende Weg und desto höher auch die Absorption im Volumen.

Alternativ kann man auch, wie in Fig.7 gezeigt, eine Linse 13 - hier beispielhaft aus dem Linsensystem 8 - zur Volumenabsorption verwenden. Hier macht man sich, ähnlich wie bei der oben erwähnten Platte 12, auch den Effekt der unterschiedlichen Weglängen und der damit zusammenhängenden unterschiedlichen Absorption zu nutze, allerdings läßt sich die Linse auch an einer Position im System einsetzen, wo die Strahldivergenz klein ist oder sogar gegen Null geht. Die unterschiedlichen Weglängen kommen dann aufgrund der Form der Linse zustande - bei einer positiv brechenden, konvexen Linse beispielsweise legen Strahlen, die in der Näher der optischen Achse auf die Linse treffen, in dieser einen längeren Weg zurück als Strahlen, die am Rand der Linse auf diese treffen; bei negativ brechenden, konkaven Linsen ist es genau umgekehrt.

Die intensitätsverändernden optischen Elemente, die hier beispielhaft für das Emulationsabbildungssystem im Maskeninspektionssystem betrachtet wurden, lassen sich mit vergleichbaren Eigenschaften in ähnlicher Weise an grundsätzlich den gleichen Stellen im Scannerabbildungssystem 3 verwenden.

Bezugszeichenliste

| | |
|---|---|
| 1 | Lichtstrahl |
| 2 | Maske |
| 3 | Scannerabbildungssystem |
| 4 | Photolackschicht |
| 5 | Emulationsabbildungssystem |
| 6 | CCD-Kamera |
| 7, 8 | Linsensystem |
| 9, 10, 11 | Filter |
| 12 | planparallele Platte |
| 13 | Linse |

**Patentansprüche**

1. Verfahren, bei dem ein Abbildungssystem mit hoher Apertur emuliert wird, wobei von einer Probe kommendes Licht mit einem Emulationsabbildungssystem auf einen ortsauflösenden Detektor abgebildet wird, zur Bestimmung einer korrigierten Intensitätsverteilung in der Bildebene des Emulationsabbildungssystems, mittels Anordnung und Beleuchtung einer Maske, Lenkung des von der Maske kommenden Lichtes auf einen ortsauflösenden Detektor, Aufzeichnung eines Signals mit dem ortsauflösenden Detektor und Berechnung der Intensitätsverteilung aus dem Signal, wobei bei dieser Berechnung die numerische Apertur in der Bildebene des Abbildungssystems mit hoher Apertur berücksichtigt wird, **dadurch gekennzeichnet, daß** eine komplexe Amplitudenverteilung in der Austrittspupille bestimmt wird, die Amplitudenverteilung mit einer vorgegebenen Apodisierungskorrektur verknüpft wird, und aus der geänderten Amplitudenverteilung ein Bild mit korrigierter Apodisierung berechnet wird.

2. Verfahren nach Anspruch 1, **dadurch gekennzeichnet, dass** zur Bestimmung der komplexen Amplitudenverteilung in der Austrittspupille die Phasenverteilung des einfallenden Lichts bestimmt wird und anhand der Phasenverteilung die komplexe Amplitudenverteilung rekonstruiert wird.

3. Verfahren nach einem der Ansprüche 1 oder 2, **dadurch gekennzeichnet, daß** die komplexe Amplitudenverteilung für eine Anzahl Punkte mit den Koordinaten (p,q) in der Austrittspupille bestimmt und mit der Apodisierungskorrektur verknüpft wird.

4. Verfahren nach einem der Ansprüche 1 bis 3, **dadurch gekennzeichnet, daß** als Apodisierungskorrektur eine im wesentlichen der im Emulationsabbildungssystem vorhandenen Apodisierung entsprechende Apodisierung vorgegeben wird und die Amplitudenverteilung durch diese dividiert wird, so daß die vorhandene Apodisierung durch die Verknüpfung mindestens teilweise kompensiert wird.

5. Verfahren nach Anspruch 4, **dadurch gekennzeichnet, daß** als Apodisierungskorrektur die natürliche und / oder technische Apodisierung des Emulationsabbildungssystems vorgegeben werden.

6. Verfahren nach einem der Ansprüche 1 bis 5, **dadurch gekennzeichnet, daß** als Apodisierungskorrektur eine im wesentlichen der im emulierten Abbildungssystem vorhandenen Apodisierung entsprechende Apodisierung vorgegeben wird und die Amplitudenverteilung mit dieser multipliziert wird, so daß die im emulierten Abbildungssystem vorhandene Apodisierung mindestens näherungsweise generiert wird.

7. Verfahren nach Anspruch 6, **dadurch gekennzeichnet, daß** als Apodisierungskorrektur die natürliche und / oder technische Apodisierung des emulierten Abbildungssystems vorgegeben wird.

8. Verfahren nach Anspruch 7, bei dem ein Photolithographiescanner emuliert wird, **dadurch gekennzeichnet, daß** die Apodisierungskorrektur in Abhängigkeit von der numerischen Apertur des Photolithographiescanners und vom emulierten Photolack vorgegeben wird.

9. Verfahren nach Anspruch 8, **dadurch gekennzeichnet, daß** die natürliche Apodisierung $T(p,q)$ des Photolithographiescanners gemäß des Aus-

drucks

$$T(p,q) = \left( \frac{1}{1 - \left(\dfrac{p}{n'}\right)^2 - \left(\dfrac{q}{n'}\right)^2} \right)^{\frac{1}{4}}$$

bestimmt wird, wobei T die Amplitudentransmission, p und q die dimensionslosen Pupillenkoordinaten und n' die Brechzahl des verwendeten Photolacks ist.

10. Verfahren, bei dem ein Abbildungssystem mit hoher Apertur emuliert wird, wobei von einer Probe kommendes Licht mit einem Emulationsabbildungssystem auf einen ortsauflösenden Detektor abgebildet wird, zur Bestimmung der Intensitätsverteilung in der Bildebene des Emulationsabbildungssystems mittels Anordnung und Beleuchtung einer Maske, Auswahl mindestens eines intensitätsverändernden optischen Elementes, mit dem eine vorgegebene Intensitätsverteilung in der Austrittspupille erzeugt wird, Einbringung oder Zuschaltung des mindestens einen intensitätsverändernden optischen Elements in den Strahlengang zur Veränderung der Apodisierung, Lenkung des von der Maske kommenden Lichtes durch dieses intensitätsverändernde optische Element auf einen ortsauflösenden Detektor, wobei das intensitätsverändernde optische Element in Abhängigkeit von der numerischen Apertur in der Bildebene des Abbildungssystems mit hoher Apertur gewählt wird, **dadurch gekennzeichnet, daß** eine im wesentlichen der natürlichen und / oder technischen Apodisierung eines emulierten Abbildungssystems entsprechende Intensitätsverteilung vorgegeben wird, so daß diese wenigstens näherungsweise erzeugt wird.

11. Verfahren nach Anspruch 10, **dadurch gekennzeichnet, daß** das intensitätsverändernde optische Element zur Erzeugung der vorgegebenen Intensitätsverteilung angesteuert wird.

12. Verfahren nach einem der Ansprüche 10 oder 11, **dadurch gekennzeichnet, daß** die Intensität durch das intensitätsverändernde optische Element verstärkt wird.

13. Verfahren nach einem der Ansprüche 10 bis 12, bei dem ein Photolithographiescanner emuliert wird, **dadurch gekennzeichnet, daß** die Intensitätsverteilung in Abhängigkeit von der numerischen Apertur des Scanners und vom emulierten Photolack vorgegeben wird.

**Claims**

1. A method in which a high-aperture imaging system is emulated, wherein light coming from a specimen is imaged onto a spatially resolving detector by means of an emulation imaging system, for determining a corrected intensity distribution in the image plane of the emulation imaging system by means of arranging and illuminating a mask, guiding the light coming from the mask onto a spatially resolving detector, recording a signal by means of the spatially resolving detector, and computation of the intensity distribution from the signal, this computation allowing for the numerical aperture in the image plane of the high-aperture imaging system, **characterized in that** a complex amplitude distribution in the exit pupil is determined, the amplitude distribution is linked with a specified apodization correction, and an image with corrected apodization is computed from the changed amplitude distribution.

2. A method as claimed in Claim 1, **characterized in that**, for the determination of the complex amplitude distribution in the exit pupil, the phase distribution of the incident light is determined, and the complex amplitude distribution is reconstructed on the basis of the phase distribution.

3. A method as claimed in any one of Claims 1 or 2, **characterized in that** the complex amplitude distribution is determined in the exit pupil for a number of points having the coordinates (p,q), and linked with the apodization.

4. A method as claimed in any one of Claims 1 through 3, **characterized in that**, as an apodization correction, an apodization is specified that essentially corresponds to the apodization existing in the emulation imaging system, and the amplitude distribution is divided by it, so that the existing apodization is at least partially compensated by this linking.

5. A method as claimed in Claim 4, **characterized in that**, as an apodization correction, the natural and / or technical apodization of the emulation imaging system are / is specified.

6. A method as claimed in any one of Claims 1 through 5, **characterized in that**, as an apodization correction, an apodization is specified that essentially corresponds to the apodization existing in the emulated imaging system, and the amplitude distribution is multiplied with it, so that the apodization existing in the emulated imaging system is at least approximately generated.

7. A method as claimed in Claim 6, **characterized in that**, as an apodization correction, the natural and / or technical apodization of the emulated imaging system is specified.

8. A method as claimed in Claim 7, in which a photolithographic scanner is emulated, **characterized in that** the apodization correction is specified as a function of the numerical aperture of the photolithographic scanner and of the emulated photoresist.

9. A method as claimed in Claim 8, **characterized in that** the natural apodization T(p,q) of the photolithographic scanner is determined according to the expression

$$T(p,q) = \left( \cfrac{1}{1 - \left(\cfrac{p}{n'}\right)^2 - \left(\cfrac{q}{n'}\right)^2} \right)^{\frac{1}{4}}$$

where T denotes the amplitude transmission, p and q denote the dimensionless pupil coordinates, and n' denotes the index of refraction of the photoresist used.

10. A method in which a high-aperture imaging system is emulated, wherein light coming from a specimen is imaged onto a spatially resolving detector by means of an emulation imaging system, for determining the intensity distribution in the image plane of the emulation imaging system by means of arranging and illuminating a mask, selecting at least one intensity-changing optical element by which a specified intensity distribution in the exit pupil is generated, inserting or switching the at least one optical element into the ray path for changing the apodization, guiding the light coming from the mask through this intensity-changing optical element onto a spatially resolving detector, with the intensity-changing optical element being selected as a function of the numerical aperture in the image plane of the high-aperture imaging system, **characterized in that** an intensity distribution is specified that essentially corresponds to the natural and / or technical apodization of an emulated imaging system, so that this intensity distribution is generated at least approximately.

11. A method as claimed in Claim 10, **characterized in that** the intensity-changing optical element is controlled in order to generate the specified intensity distribution.

12. A method as claimed in any one of Claims 10 or 11, **characterized in that** the intensity-changing optical element.

13. A method as claimed in any one of Claims 10 through 12, in which a photolithographic scanner is emulated, **characterized in that** the intensity distribution is specified as a function of the scanner's numerical aperture and of the emulated photoresist.

**Revendications**

1. Procédé dans lequel un système d'imagerie avec une grande ouverture est émulé, la lumière provenant d'un échantillon étant représentée, avec un système d'imagerie par émulation, sur un détecteur à résolution locale, pour la détermination d'une répartition d'intensité corrigée dans le plan d'image du système d'imagerie par émulation, à l'aide de la disposition et de l'éclairage d'un masque, de l'orientation de la lumière provenant du masque vers un détecteur à résolution locale, de l'enregistrement d'un signal avec le détecteur à résolution locale et du calcul de la répartition d'intensité à partir du signal, l'ouverture numérique dans le plan d'image du système d'imagerie à grande ouverture étant prise en compte lors de ce calcul, **caractérisé en ce qu'**une répartition d'amplitude complexe est déterminée dans la pupille de sortie, la répartition d'amplitude est combinée avec une correction d'apodisation prédéterminée et, à partir de la répartition d'amplitude corrigée, une image avec une apodisation corrigée est calculée.

2. Procédé selon la revendication 1, **caractérisé en ce que**, pour la détermination de la répartition d'amplitude complexe dans la pupille de sortie, la répartition de phase de la lumière incidente est déterminée et la répartition d'amplitude complexe est reconstituée à l'aide de la répartition de phase.

3. Procédé selon l'une des revendications 1 ou 2, **caractérisé en ce que** la répartition d'amplitude complexe est déterminée pour plusieurs points avec les coordonnées (p, q) dans la pupille de sortie et combinée avec la correction d'apodisation.

4. Procédé selon l'une des revendications 1 à 3, **caractérisé en ce que**, en tant que correction d'apodisation, une apodisation correspondant à l'apodisation existante dans le système d'imagerie par émulation est prédéterminée et la répartition d'amplitude est divisée par celle-ci, de façon à ce que l'apodisation existante soit compensée au moins partiellement par cette combinaison.

5. Procédé selon la revendication 4, **caractérisé en ce**

**que**, en tant que correction d'apodisation, l'apodisation naturelle et/ou technique du système d'imagerie par émulation est prédéterminée.

6. Procédé selon l'une des revendications 1 à 5, **caractérisé en ce que**, en tant que correction d'apodisation, une apodisation correspondant globalement à l'apodisation existante dans le système d'imagerie émulé est prédéterminée et la répartition d'amplitude est multipliée par celle-ci, de façon à ce que l'apodisation existante dans le système d'imagerie émulé soit générée au moins approximativement.

7. Procédé selon la revendication 6, **caractérisé en ce que**, en tant que correction d'apodisation, l'apodisation naturelle et/ou technique du système d'imagerie émulé est prédéterminée.

8. Procédé selon la revendication 7, **caractérisé en ce que** la correction d'apodisation est prédéterminée en fonction de l'ouverture numérique du scanner de photolithographie et de la résine photosensible émulée.

9. Procédé selon la revendication 8, **caractérisé en ce que** l'apodisation naturelle T(p,q) du scanner de photolithographie est déterminé par la formule

$$T(p,q) = \left( \frac{1}{1 - \left(\frac{p}{n'}\right)^2 - \left(\frac{q}{n'}\right)^2} \right)^{\frac{1}{4}}$$

T étant la transmission de l'amplitude, p et q les coordonnées sans dimensions de la pupille et n' l'indice de réfraction de la résine photosensible utilisée.

10. Procédé dans lequel un système d'imagerie à grande ouverture est émulé, la lumière provenant d'un échantillon étant représentée avec un système d'imagerie par émulation sur un détecteur à résolution locale, pour la détermination de la répartition d'intensité dans le plan d'image du système d'imagerie par émulation à l'aide de la disposition et de l'éclairage d'un masque, de la sélection d'au moins un élément optique modifiant l'intensité, avec lequel une répartition d'intensité prédéterminée est générée dans la pupille de sortie, de l'insertion ou de l'ajout de l'au moins un éléments optique modifiant l'intensité dans le trajet des faisceaux pour la modification de l'apodisation, de l'orientation de la lumière provenant du masque, par cet élément optique modifiant l'intensité, vers un détecteur à résolution locale, l'élément optique modifiant l'intensité étant choisi en fonction de l'ouverture numérique dans le plan d'image du système d'imagerie à grande ouverture, **caractérisé en ce qu'**une répartition d'intensité correspondant globalement à l'apodisation naturelle et/ou technique d'un système d'imagerie émulé est prédéterminée, de façon à ce que celle-ci soit générée au moins approximativement.

11. Procédé selon la revendication 10, **caractérisé en ce que** l'élément optique modifiant l'intensité est piloté pour générer la répartition d'intensité prédéterminée.

12. Procédé selon l'une des revendications 10 ou 11, **caractérisé en ce que** l'intensité est renforcée par l'élément optique modifiant l'intensité.

13. Procédé selon l'une des revendications 10 à 12, dans lequel un scanner de photolithographie est émulé, **caractérisé en ce que** la répartition d'intensité est prédéterminée en fonction de l'ouverture numérique du scanner et de la résine photosensible émulée.

Stand der Technik

Fig.1a

Fig.1b

EP 1 922 587 B1

Fig.2

Fig.3a

100%

Transmission

0%

Rand     Mitte     Rand

Pupillenhöhe

Fig.3b

Fig.4

Fig.5

Fig.6

Fig.7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20010007495 A1
- EP 0689099 A1
- WO 03092256 A2
- EP 0628806 A2